(19) **Europäisches Patentamt / European Patent Office / Office européen des brevets**

(11) **EP 1 630 568 B1**

(12) **EUROPÄISCHE PATENTSCHRIFT**

(45) Veröffentlichungstag und Bekanntmachung des Hinweises auf die Patenterteilung:
**12.03.2008 Patentblatt 2008/11**

(51) Int Cl.:
***G01R 33/3875*** *(2006.01)*

(21) Anmeldenummer: **05016838.4**

(22) Anmeldetag: **03.08.2005**

(54) **Verfahren zur dynamischen Erfassung und Veränderung der Magnetfeldverteilung bei Messungen der Magnetresonanz (NMR)**

Method for dynamic acquisition and updating of the magnetic field distribution during NMR measurements

Méthode d'acquisition et de correction dynamiques de champ magnétique pendant mesures de RMN

(84) Benannte Vertragsstaaten:
**AT CH DE GB LI**

(30) Priorität: **11.08.2004 DE 102004038917**

(43) Veröffentlichungstag der Anmeldung:
**01.03.2006 Patentblatt 2006/09**

(73) Patentinhaber: **Universitätsklinikum Freiburg**
**78106 Freiburg (DE)**

(72) Erfinder:
 • **Hennig, Jürgen**
   **79110 Freiburg (DE)**
 • **Speck, Oliver**
   **79110 Freiburg (DE)**
 • **Zaitse, Maxim**
   **79117 Freiburg (DE)**

(74) Vertreter: **Kohler Schmid Möbus**
**Patentanwälte**
**Ruppmannstrasse 27**
**70565 Stuttgart (DE)**

(56) Entgegenhaltungen:
 • R. GRUETTER, I. TKAC: "Field mapping without reference scan using asymmetric echo-planar techniques" MAGNETIC RESONANCE IN MEDICINE, Bd. 43, Februar 2000 (2000-02), Seiten 319-323, XP002294864 ISSN: 0740-3194
 • ZENG H ET AL: "Image distortion correction in EPI: comparison of field mapping with point spread function mapping" MAGNETIC RESONANCE IN MEDICINE, Bd. 48, Juli 2002 (2002-07), Seiten 137-146, XP002359901 ISSN: 0740-3194
 • TERPSTRA M ET AL: "Localized eddy current compensation using quantitative field mapping" JOURNAL OF MAGNETIC RESONANCE, Bd. 131, März 1998 (1998-03), Seiten 139-143, XP002359902 ISSN: 1090-7807

**Beschreibung**

Die Erfindung betrifft ein Verfahren der Magnetresonanz (NMR) zur schnellen dynamischen ortsaufgelösten Messung der zeitlichen Veränderung von NMR-Signalen durch wiederholte Datenaufnahmen in Einzelmessungen mit gegenüber einem zu beobachtenden Parameter empfindlichen Messsequenzen in einer NMR-Apparatur mit Magnetfeld korrigierenden Shimspulen.

Die in der Bildgebung mittels Kernspintomographie heute allgemein verwendeten Verfahren verwenden räumlich veränderliche Magnetfelder zur Ortskodierung der beobachteten Spins. Diese zur Ortskodierung verwendeten Magnetfelder werden durch zeitlich veränderliche Magnetfeldgradienten dem Grundfeld des äußeren Magneten überlagert. Durch die Aufnahme des zeitlich veränderlichen Kernresonanzsignals wird dabei ein zwei- oder dreidimensionaler Datensatz erzeugt, welcher durch entsprechend mehrdimensionale Fourier-Transformation in entsprechende räumliche Abbildungen umgesetzt wird. Eine ortstreue Abbildung ergibt sich dabei nur dann, wenn das Grundfeld im beobachteten Volumen konstant und homogen ist und wenn die verwendeten Gradienten zu einer exakt linearen Änderung des Magnetfeldes in Gradientenrichtung führen, bzw. wenn die Abweichungen von diesem idealen Verhalten bekannt sind und daher korrigiert werden können.

Insbesondere in Bezug auf das Grundfeld wird die Homogenität der Magnetfeldverteilung zum einen durch technische Imperfektionen, zum andern aber auch auf Grund der durch die unterschiedlichen magnetischen Eigenschaften des untersuchten Objektes bedingten so genannten Suszeptibilitätseffekte beeinträchtigt. Dadurch entstehen Bildverzerrungen, welche je nach verwendeter Aufnahmesequenz im Bereich mehrerer Millimeter bis Zentimeter liegen können. Zudem können sich Suszeptibilitätseffekte als Signalmodulationen beziehungsweise Signalauslöschungen in bestimmten Arealen des untersuchten Objekts äußern. Ein hierfür besonders anfälliges und für die schnelle ortskodierte Messung zeitlich veränderlicher Signalintensitäten häufig eingesetztes Verfahren ist die Echo-Planar Bildgebung (EPI). Dieses Verfahren zeichnet sich dadurch aus, dass durch eine Kombination aus Gradientenschaltung und Datenaufnahme nach einem Anregungspuls viele Rohdaten (k- Raum-Punkte oder -Zeilen) aufgenommen werden [4].

Das EPI-Verfahren zeigt lokale geometrische Verzerrungen aufgrund von Magnetfeldinhomogenitäten $\Delta B_0(x,y,z)$, die durch den Magneten selbst, aber vor allem durch das zu untersuchende Objekt verursacht werden. Diese Fehlabbildungen $\Delta y(x,y,z)$ treten von allem in Phasenkodierrichtung auf und hängen von der Auslesebandbreite BW sowie der Matrixgröße kx * ky und dem Aufnahmefeld FOV (field of view) ab: $\Delta y(x,y,z) = \Delta B_0(x,y,z) * \gamma * kx / BW * FOV_y/ky$.

Magnetfeldinhomogenitäten können mit der Zeit variieren. Diese Variationen werden zum einen durch Geräteinstabilitäten und zum anderen durch Bewegungen des Objektes innerhalb und außerhalb des Aufnahmefeldes und somit durch die Verlagerung von Substanzen mit magnetischen Eigenschaften, welche sich von Luft unterscheiden und das Feld beeinflussen, verursacht.

Die durch die erwähnten Effekte hervorgerufenen Magnetfeldverzerrungen werden mit so genannten Shimspulen kompensiert, welche Magnetfelder bestimmter Geometrie erzeugen und diese dem Hauptfeld überlagern. Die Shimspulen werden normalerweise vor einer Messung justiert, indem die Magnetfeldverteilung ermittelt und Shimströme zur möglichst optimalen Kompensation von Feldinhomogenitäten errechnet und angewandt werden.

Durch entsprechende Referenzmessungen etwa mittels 'field mapping' [3] oder 'point spread function mapping' [5], [7] lassen sich die Imperfektionen der Magnetfelder experimentell bestimmen. Als Ergebnis dieser Referenzmessungen erhält man $\Delta y(x,y,z)$ oder $\Delta B_0(x,y,z)$ und kann somit die Verzerrungen korrigieren.

Kleine Bewegungen, wie sie etwa bei funktionellen MRT (Magnetresonanztomografie) - Messungen zwischen den Aufnahmen einzelner Datensätze vorkommen können, können so prospektiv [6], oder retrospektiv [1] korrigiert werden. Die durch diese Bewegungen induzierten Magnetfeldänderungen können jedoch prinzipiell nicht aus der Anfangs-Magnetfeldverteilung und der Bewegung des Objektes errechnet werden. Zudem werden Faktoren, die außerhalb des erfassten Messvolumens liegen und Einfluss auf die Magnetfeldverteilung im Messvolumen nehmen, nicht erfasst.

Sämtliche bisher verwendeten Verfahren beruhen auf der Durchführung entsprechender Justierroutinen, welche je nach verwendeter Methode zwischen 10-100 s in Anspruch nehmen. Solche Justierungen werden im Allgemeinen vor Beginn einer Messung durchgeführt, unter der Annahme, dass die entsprechenden Inhomogenitäten über den Verlauf der Messung unveränderlich sind.

Diese Annahme ist jedoch nur in grober Näherung gerechtfertigt. Insbesondere bei Experimenten zur Messungen der zeitlichen Veränderung des Signals erfolgt die Datenaufnahme durch mehrfache Wiederholung einer, für den zu beobachtenden Parameter besonders empfindlichen, Sequenz über eine Zeitraum, der mehrere Minuten beanspruchen kann. Typische Beispiele für solche sequentiellen Messungen sind Messungen der Gehirnaktivierung mittels BOLD-Methoden wie EPI oder auch Spiral-imaging oder auch Perfusionsmessungen durch Beobachtung der durch einen Kontrastmittelbolus bewirkten Signaländerung.

Bei solchen Messungen kann es durch eine Reihe von Mechanismen zu zeitlichen Änderungen der Magnetfeldverteilung während der Wiederholungsmessungen kommen, welche zu erheblichen Messfehlern des zu bestimmenden Parameters führen können. Hierzu tragen folgende Effekte bei: Durch die längere Anwendung sehr schneller und starker Magnetfeldgradienten kommt es zu Änderungen in der Temperaturverteilung im Gradientenrohr und in den Shimspulen. Diese führen zu technisch bedingten Änderungen der durch die Ströme in diesen Spulen hervorgerufenen Magnetfeldverteilungen. Darüber hinaus ändern sich durch Bewegung des Patienten die erwähnten Suszeptibilitätseffekte, die aus Wechselwirkung des Gewebes mit dem äußeren Feld resultieren. Dies führt zu Verzerrungen aber auch zu Änderungen in der Signalintensität. Diese Effekte sind nicht durch einfache geometrische Korrekturen zu korrigieren. Solche patientenbedingten Änderungen können auch durch Bewegungen in Bereichen außerhalb des eigentlichen Messfensters entstehen. So wurde gezeigt, dass in Hochfeldsystemen selbst die atembedingte Bewegung des Brustkorbs zu relevanten Feldänderungen im Gehirn führt.

Die vorliegende Erfindung schlägt ein Verfahren vor, mit dem die Veränderungen der Magneffeldverteilung durch die oben genannten Faktoren während der Messung dynamische erfasst und durch entsprechende Neuberechnung von Ay(x,y,z) oder $\Delta B_0(x,y,z)$ sowie eine Anpassung der Shimströme kompensiert werden, um die Magnetfeldverteilung für folgende Messungen wieder möglichst identisch zur Ausgangs-Mag netfeldverteilung zu gestalten.

Die Erfindung besteht in dem in Anspruch 1 definierten Verfahren.

Die Bestimmung der Magnetfeldverteilung erfolgt dabei vorzugsweise in periodischen Abständen. Die residuellen Magnetfeldänderungen können bei der Rekonstruktion der Bilddaten berücksichtigt werden, indem die Korrekturfelder $\Delta y(x,y,z)$ oder $\Delta B_0(x,y,z)$ aktualisiert und angewandt werden. Durch das erfindungsgemäße Verfahren werden die Abweichungen vom Ausgangswert gering gehalten und somit die anzubringenden Korrekturen minimiert. Die üblicherweise für die Messung der Magnetfeldverteilung eingesetzten Verfahren sind zu einer solchen dynamischen (und im Idealfall kontinuierlichen) Korrektur nicht geeignet, da sie sowohl in Bezug auf die benötigten Datenaufnahmeschritte als auch der Nachverarbeitungsalgorithmen zeitlich zu aufwendig sind.

In einer ersten Verfahrensvariante wird die Magnetfeldverteilung durch Aufnahmeschritte mittels so genannter ‚Navigatoren' ermittelt wird, wobei ein Navigator jeweils in Form einer Aufnahme eines im k-Raum eindimensionalen Signals eingesetzt wird, so dass zur Bestimmung der drei-dimensionalen Magnetfeldverteilung mindest n=3 Navigatoren in den drei Raumrichtungen erforderlich sind. Nach dem auf FASTMAP basierenden Verfahren [2] werden die Magnetfeldverteilungen durch sequentielle Messung eindimensionaler Profile entlang einer kartesischen Hauptachse des Untersuchungsfeldes ermittelt und daraus die Magnetfeldabweichungen von der idealen Homogenität auf Basis der räumlichen Verteilung der Magnetfelder, welche durch die Shimspulen erzeugt werden, berechnet.

In einer Variante dieses Verfahrens werden bei jeder Einzelmessung nur m Navigatoren aufgenommen, wobei 1 <m ≤n, so dass die vollständige Bestimmung der räumlichen Magnetfeldverteilung erst nach n/m Einzelmessungen erfolgt, wobei aber nach jeder Einzelmessungen aus den jeweils vorangegangenen n/m Einzelmessungen eine neue Magnetfeldverteilung bestimmt wird.

In einer weiteren Variante des erfindungsgemäßen Verfahrens erfolgt die Magnetfeldverteilung durch zusätzlich eingefügte Messungen mittels zwei- oder dreidimensionaler, räumlich niedrig aufgelöster inhomogenitätsempfindlicher Sequenzen, wie beispielsweise dem Echo-Planar Imaging Verfahren, wobei zur Bestimmung der lokalen feldbedingten Resonanzfrequenzen mindestens zwei Sequenzen bei unterschiedlichen Echozeiten durchgeführt werden.

Bei einer Weiterbildung dieses Verfahrens wird bei jeder Einzelmessung nur ein Teil der zur vollständigen Messung der Magnetfeldverteilung erforderlichen Daten aufgenommen, so dass die vollständige Bestimmung der räumlichen Magnetfeldverteilung erst nach mehreren Einzeimessungen erfolgt, wobei aber nach jeder Einzelmessung aus den jeweils vorangegangenen Einzelmessungen eine neue Magnetfeldverteilung bestimmt wird. Diese Messungen können mit einem geringen Anregungskippwinkel $\alpha$ durchgeführt werden, um das Signal der laufenden Messung nicht oder nur sehr geringfügig zu beeinflussen.

Eine weitere Variante des erfindungsgemäßen Verfahrens sieht vor, dass die Magnetfeldverteilung ohne zusätzliche Messschritte direkt aus der Phasenänderung der Bilddaten, verursacht durch periodische Änderung der Echozeit, berechnet wird. Dies ist insbesondere dann vorteilhaft, wenn die Änderungen zwischen zwei aufeinander folgenden Messungen sehr klein gegenüber den Abweichungen der Magnetfeldverteilung von einem ideal homogenen Magnetfeld sind, was im Allgemeinen der Fall ist. Hierdurch entfallen viele der Schwierigkeiten, die üblicherweise bei der Berechnung von Magnetfeldverteilungen aus kernspintomographischen Daten auftreten. Die Magnetfeldstärke wird im Allgemeinen aus der Phasenentwicklung des NMR-Signals $\Phi$ bestimmt. Wird diese zu unterschiedlichen Zeiten gemessen, so kann aus der Phasendifferenz die Larmorfrequenz und somit die Magnetfeldstärke errechnet werden nach $B_0(x,y,z) = [\Phi (x,y,z,t2)- \Phi (x,y,z,t1)] / (t2-t1) / \gamma$.

Für kleine Änderungen von $B_0(x,y,z)$ kann die Zuordnung einer Phasendifferenz zu einer Magnetfeldänderung eindeutig gemacht werden und somit die Änderung der Magnetfeldverteilung sequentiell aus der zeitlichen Änderung der Phase der Bilddaten berechnet werden ("dynamische Referenz"). Das Magnetfeld kann demnach mithilfe des Vorwissens aus der Referenzmessung kontinuierlich eindeutig erfasst werden.

Da die Signalphase in den meisten Fällen jedoch nicht eindeutig, sondern nur modulo 2*Pi bestimmt werden kann, müssen in der Regel aufwendige Algorithmen zur Entfaltung der Daten eingesetzt werden, welche besonders bei diskontinuierlichen Objekten häufig versagen. Besonders bevorzugt ist daher eine Variante des erfindungsgemäßen Verfahrens, bei dem die Aufnahmeschritte für eine Referenzmessung zur Magnetfeldverteilung zu Beginn der Messung durchgeführt werden und während der Messung jeweils nur noch die Änderung der Magnetfeldverteilung durch weitere Aufnahmeschritte periodisch wiederholend gemessen wird (‚statische Referenz'). Die aktuelle Magnetfeldverteilung wird aus der Ausgangs-Magnetfeldverteilung, welche in einer Referenzmessung in s Schritten ermittelt wird, und deren Änderungen errechnet.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:

Fig. 1A    ein Schema des erfindungsgemäßen Verfahrens zur dynamischen Anpassung der Magnetfeldverteilung ;

Fig. 1B    ein Schema einer Variante des erfindungsgemäßen Verfahrens entsprechend Fig. 1A, wobei jedoch die Einzelaufnahmen der Magnetfeldverteilung nach jeweils nacq Aufnahmeschritten erfolgen;

Fig. 2    ein Schema einer weiteren Variante des erfindungsgemäßen Verfahrens, bei der vor jeder Einzelaufnahme nur ein Anteil der zur Messung der Magnetfeldverteilung benötigten Daten aufgenommen werden;

Fig. 3    ein Schema einer weiteren Variante des erfindungsgemäßen Verfahrens, bei der vor jeder Einzelaufnahme ein Aufnahmeschritt zur Messung der Magnetfeldverteilung mittels einer EPI-Sequenz erfolgt;

Fig. 4    ein Schema einer weiteren Variante des erfindungsgemäßen Verfahrens mit einer statischen Referenz; und

Fig. 5    ein Schema einer weiteren Variante des erfindungsgemäßen Verfahrens, bei welchem die Verteilung des Magnetfeldes durch die Aufnahmesequenz selbst erfolgt.

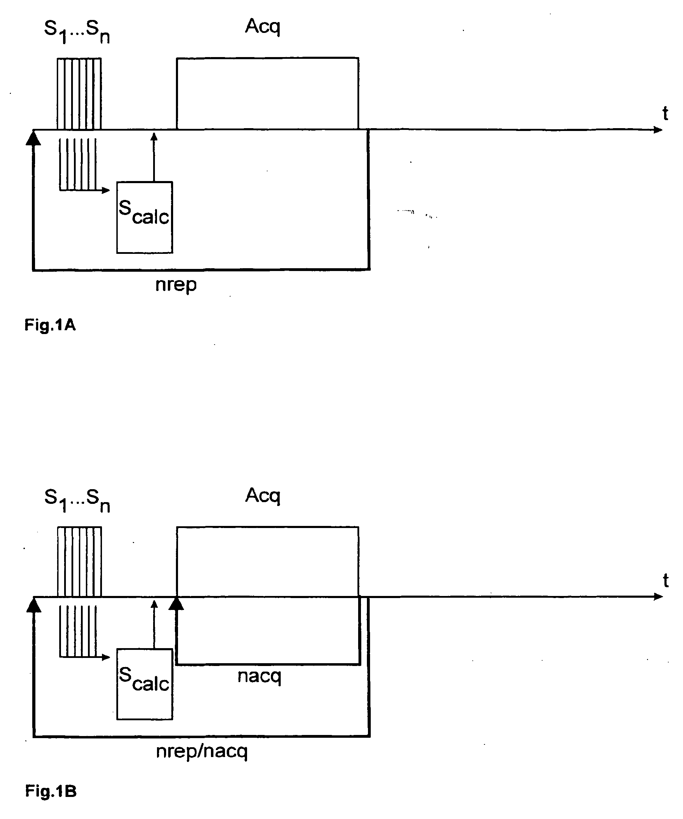

**Fig.1A** zeigt ein Schema des Verfahrens zur dynamischen Anpassung der Magnetfeldverteilung bei nrep-facher wiederholter Datenaufnahme, wobei vor jeder Einzelmessung **Acq** die Magnetfeldverteilung in n Aufnahmeschritten $S_1...S_n$ einer Shimsequenz gemessen und im nachfolgenden Berrechnungsschritt $S_{calc}$ die zur Kompensation der Feldinhomogenitäten benötigten Shimströme berechnet und angewendet werden.

Die Aufnahmeschritte $S_1...S_n$ der zusätzlich eingefügte periodische Shimsequenz können auf Navigatormessungen nach dem Verfahren FASTMAP basieren. Hierfür werden typischerweise jeweils in einer der drei Hauptrichtungen des Magnetfeldes mindestens eine (für die bisherige Anwendung zur einmaligen statischen Feldmessung typischerweise auch mehrfache) Messungen durchgeführt. Die Zahl n der Messschritte ist daher typischerweise $n \geq 3$.

In einer Modifikation dieses Ansatzes ist die Messung und Kompensation der Magnetfeldverteilung nicht vor jeder Einzelmessung Acq vorgesehen, die Shimsequenz wird vielmehr nach jeweils nacq Einzelmessungen Acq eingesetzt. **Fig.1B** zeigt ein derartiges Schema. Die gesamte Aufnahme der nrep Einzelmessungen Acq erfolgt demnach nach nrep/nacq Wiederholungen.

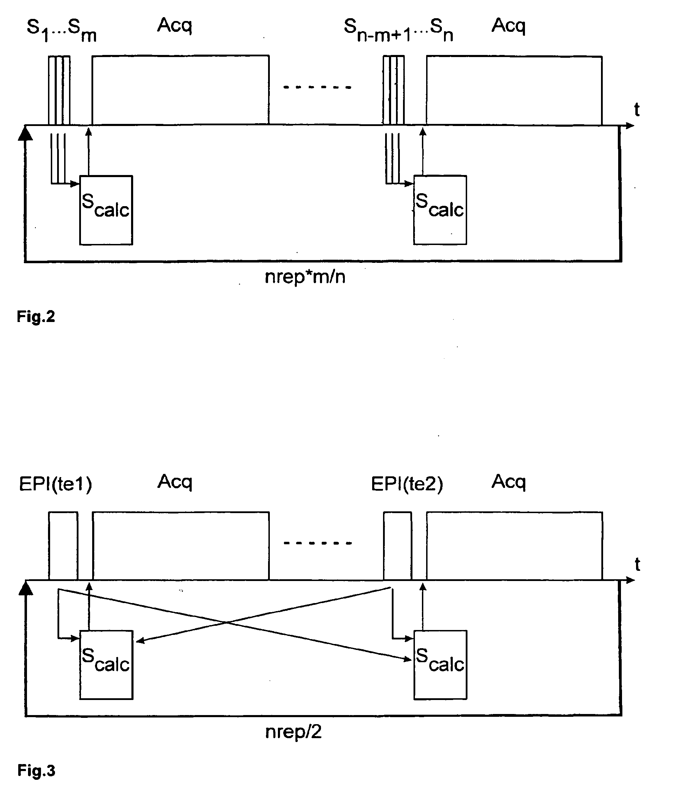

In **Fig.2** ist ein Aufnahmeschema einer Verfahrensvariante dargestellt, bei dem vor jeder Einzelmessungen Acq nur ein Anteil m (mit $1 \leq m < n$) der n Aufnahmeschritte $S_{1...n}$ der Shimsequenz ausgeführt und somit auch nur ein Anteil m der zur Messung der Magnetfeldverteilung benötigten Daten aufgenommen wird. Zur Berechnung werden diese m Aufnahmeschritte $S_{1...m}$ dann jeweils im Berrechnungsschritt erneuert, so dass die insgesamt zur Berechnung notwendigen n Aufnahmeschritte $S_{1...n}$ aus den n/m vorangegangen Aufnahmen stammen. Eine vollständige dynamische Magnetfeldverteilung wird somit jeweils nach n/m Einzelschritten erreicht.

Statt der jeweils im k-Raum eindimensionalen Navigatoren kann als Shimsequenz auch eine 2-oder 3-dimensionale Messung der Magnetfeldverteilung durchgeführt werden. Eine solche kann durch Aufnahme niedrig aufgelöster EPI-Daten erfolgen, wobei die Aufnahme entweder sequentiell durch zweimalige Aufnahme von EPI-Sequenzen **EPI(te1), EPI(te2)** mit unterschiedlicher Echozeit und damit unterschiedlicher feldbedingter Phasenentwicklung des Signals erfolgt, oder aber auch durch Verfahren, bei welchen die gewünschten Daten zu unterschiedlichen Echozeiten mit einer einzigen Anregung des Spinsystems gewonnen werden. Auch solche Aufnahmen lassen sich entsprechend der in Fig. 1 und 2 beschriebenen Schemata entweder so durchführen, dass entweder die gesamten Aufnahmeschritte $S_{1...n}$ bei jeder Einzelmessung Acq (Fig.1A) oder nach nacq Einzelmessungen Acq (Fig.1B) erfolgen, oder die Gesamtzahl der Aufnahmeschritte $S_{1...n}$ über n/m Einzelmessungen Acq verteilt wird (Fig.2). Diese Messungen können mit geringem Anregungskippwinkel $\alpha$ durchgeführt werden, um das Signal der laufenden Messung nicht oder nur sehr geringfügig zu beeinflussen.

Bei einer Variante dieses Verfahrens erfolgt vor jedem Aufnahmeschritt Acq ein Aufnahmeschritt zur Messung der Magnetfeldverteilung mittels einer EPI-Sequenz EPI(te1), EPI(te2). Die Änderungen des Magnetfeldes werden erfasst, indem die Echozeit der Shimsequenz von Einzelmessung Acq zu Einzelmessung Acq periodisch mit einer Periode np variiert wird. Somit kann nach np Wiederholungen der Einzelmessung Acq eine erneute Magnetfeldverteilung

nach

$$B_0(x,y,z) = [\Phi(x,y,z,te2) - \Phi(x,y,z,te1)] / (te2-te1) / \gamma$$

bestimmt werden, welche durch zyklischen Austausch durch die aktuellsten Messdaten nach jeder Einzelmessung Acq aktualisiert werden kann. **Fig. 3** zeigt diese Verfahrensvariante für np=2. Dies entspricht einer alternierenden Messung von jeweils zwei Datensätzen zu einer Auslesezeit.

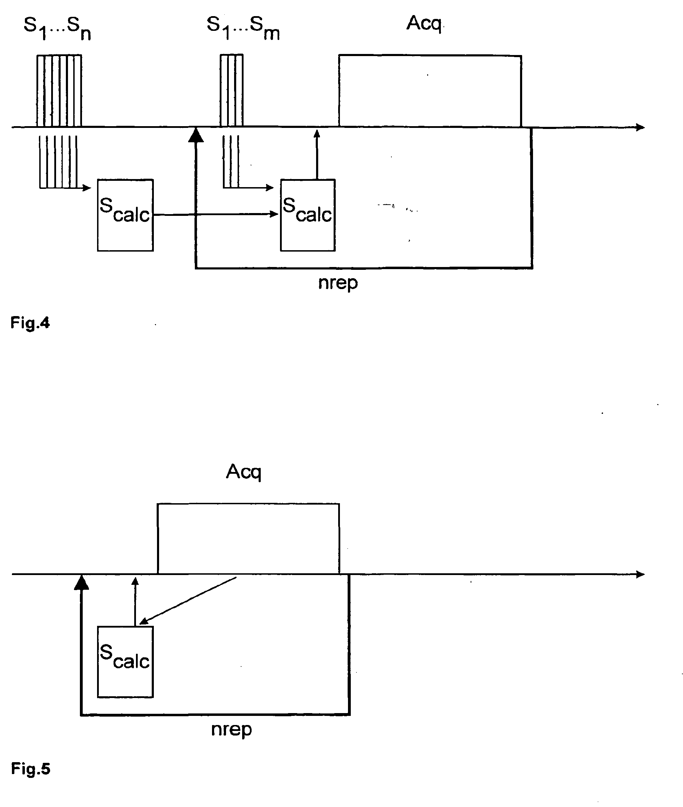

**Fig.4** zeigt ein Aufnahmeschema mit einer statischen Referenz. Hierbei wird vor der wiederholten Einzelmessung Acq mittels Aufnahmeschritte $S_{1...n}$ einer Shimsequenz eine ausführliche Messung zur Bestimmung der Magnetfeldverteilung (Referenzzustand) durchgeführt. Für die dynamische Anpassung der Verbesserung der Magnetfeldverteilung werden dann nur noch mit wenigen Aufnahmeschritten $S_{1...m}$ der Shimsequenz vor jeder Einzelmessung Acq die Abweichungen des aktuellen Zustandes von diesem Referenzzustand bestimmt.

Schließlich wird in einer weiteren Variante des erfinderischen Verfahrens die Änderung des Magnetfeldes ohne zusätzliche Messschritte direkt aus den eigentlichen Aufnahmedaten der Einzelmessungen Acq ermittelt (**Fig.5**). Dies ist dann möglich, wenn die Einzelmessungen Acq selbst sensitiv gegenüber der Magnetfeldverteilung ist, was im Allgemeinen für Verfahren, die typischerweise für solche Messungen verwendet werden (EPI, Spiral imaging etc.), der Fall ist. Durch kontinuierlichen Vergleich der Signale aufeinander folgender Einzelmessungen Acq lassen sich die lokalen Feldänderungen entsprechend

$$\Delta B_0(x,y,z) = [\Phi(x,y,z,n) - \Phi(x,y,z,n-1)] / TE / \gamma.$$

bestimmen, wobei TE die Echozeit der Messung ist.

Besonders bevorzugt ist eine Variante des Verfahrens, welche bei bekannter und reproduzierbarer Bewegung des Untersuchungsobjektes die Magnetfeldverteilung in einer dynamischen Referenzmessung für alle Positionen ermittelt und bei wiederholter Bewegung die Shimströme entsprechend anpasst.

Schließlich soll noch darauf hingewiesen werden, dass die in Fig.1-5 dargestellten Grundprinzipien der Sequenz beliebig miteinander kombinierbar sind. Auch lassen sich statt der explizit erwähnten Messverfahren für die Shimsequenz basierend auf (im k-Raum) eindimensionalen Navigatoren bzw. EPI-Verfahren zur Messung der Magnetfeldverteilung auch andere 2- oder 3- dimensionale Aufnahmeverfahren nach diesem Schema durchführen.

Das erfindungsgemäße Verfahren der Magnetresonanz (NMR) erlaubt dynamische ortsaufgelöste Messungen von NMR Signalen, bei welchem die Magnetfeldverteilung ermittelt und deren Änderung durch Anpassung der Ströme in den Magnetfeld korrigierenden Shimspulen kompensiert wird. Mit dieser neuen Methode lassen sich die geometrischen Abbildungsfehler und Signalintensitätsschwankungen, welche sich im Verlauf einer dynamischen Messung durch Bewegung der Objekts innerhalb oder außerhalb des Messvolumens, sowie durch Geräteinstabilitäten, verändern, reduzieren. Dadurch wird die Stabilität der Messung erhöht.

**Bezugszeichenliste**

$S_{1...n}$      Aufnahmeschritte
$S_{1...m}$      Aufnahmeschritte
$S_{calc}$      Berechnungsschritt
Acq      Einzelmessung
EPI(te1)      EPI-Sequenz
EPI(te2)      EPI-Sequenz

**Referenzliste**

[1] Friston, K.J., Ashburner, J., et al. (1995). "Spatial realignment and normalization of images." Hum Brain Mapp 2, 165-89.

[2] Gruetter, R. (1993). "Automatic, localized in vivo adjustment of all first- and second-order shim coils." Magn Reson Med 29(6): 804-11.

[3] Jezzard, P. and R. S. Balaban (1995). "Correction for geometric distortion in echo planar images from B0 field variations." Magn Reson Med 34(1): 65-73.

[4] Mansfield, P. (1977). "Multi-planar image formation using NMR spinechoes." J Phys C 10: L5-L58.

[5] Robson, M. D., J. C. Gore, et al. (1997). "Measurement of the point spread function in MRI using constant time imaging." Magn Reson Med 38(5): 733-40.

[6] Thesen, S., O. Heid, et al. (2000). "Prospective acquisition correction for head motion with image-based tracking for real-time fMRI." Magn Reson Med 44(3): 457-65.

[7] Zeng, H. and R. T. Constable (2002). "Image distortion correction in EPI: comparison of field mapping with point spread function mapping." Magn Reson Med 48(1): 137-46.

**Patentansprüche**

1. Verfahren der Magnetresonanz (NMR) zur schnellen dynamischen ortsaufgelösten Messung der zeitlichen Veränderung von NMR-Signalen durch wiederholte Datenaufnahmen in Einzelmessungen (Acq) mit gegenüber einem zu beobachtenden Parameter empfindlichen Messsequenzen in einer NMR-Apparatur mit Magnetfeld korrigierenden Shimspulen

   **dadurch gekennzeichnet,**
   **dass** in, von der Datenaufnahme von Einzelmessungen (Acq) zeitlich beabstandeten Aufnahmeschritten, eine vollständige (S1 ...Sn) oder teilweise (S1 ... Sm) Messung der Magnetfeldverteilung in der NMR-Apparatur erfolgt, daraus in einem Berechnungsschritt (Scalc) technisch oder physiologisch bedingte Änderungen der Magnetfeldverteilung und eine zu deren Kompensation erforderliche Änderung der Ströme in den Magnetfeld korrigierenden Shimspulen bestimmt werden,
   und die dynamischen Änderungen der Magnetfeldverteilung mittels der entsprechend geänderten Shimströme kompensiert werden.

2. Verfahren nach Anspruch 1, **dadurch gekennzeichnet, dass** die Magnetfeldverteilung durch Aufnahmeschritte ($S_1$ ... $S_n$) mittels so genannter ‚Navigatoren' ermittelt wird, wobei ein Navigator jeweils in Form einer Aufnahme eines im k-Raum eindimensionalen Signals eingesetzt wird, so dass zur Bestimmung der drei-dimensionalen Magnetfeldverteilung mindest n=3 Navigatoren in den drei Raumrichtungen erforderlich sind

3. Verfahren nach Anspruch 2, **dadurch gekennzeichnet, dass** bei jeder Einzelmessung (Acq) nur m Navigatoren, aufgenommen werden, wobei 1<m≤n, so dass die vollständige Bestimmung der räumlichen Magnetfeldverteilung erst nach n/m Einzelmessungen (Acq) erfolgt, wobei aber nach jeder Einzelmessung (Acq) aus den jeweils vorangegangenen n/m Einzelmessungen (Acq) eine neue Magnetfeldverteilung bestimmt wird.

4. Verfahren nach Anspruch 1, **dadurch gekennzeichnet, dass** die Magnetfeldverteilung durch zusätzlich eingefügte Messungen mittels zwei- oder dreidimensionaler, räumlich niedrig aufgelöster inhomogenitätsempfindlicher Sequenzen (EPI(te1), EPI(te2)) wie beispielsweise dem Echo-Planar Imaging Verfahren erfolgt, wobei zur Bestimmung der lokalen feldbedingten Resonanzfrequenzen mindestens zwei Sequenzen (EPI(te1), EPI(te2)) bei unterschiedlichen Echozeiten durchgeführt werden.

5. Verfahren nach Anspruch 4, **dadurch gekennzeichnet, dass** bei jeder Einzelmessung (Acq) nur ein Teil der zur vollständigen Messung der Magnetfeldverteilung erforderlichen Daten aufgenommen wird, so dass die vollständige Bestimmung der räumlichen Magnetfeldverteilung erst nach mehreren Einzelmessungen (Acq) erfolgt, wobei aber nach jeder Einzelmessung (Acq) aus den jeweils vorangegangenen Einzelmessungen (Acq) eine neue Magnetfeldverteilung bestimmt wird.

6. Verfahren nach Anspruch 1, **dadurch gekennzeichnet, dass** die Magnetfeldverteilung ohne zusätzliche Messschritte direkt aus der Phasenänderung der Bilddaten, verursacht durch periodische Änderung der Echozeit, berechnet wird.

**7.** Verfahren nach Anspruch 6, **dadurch gekennzeichnet, dass** die Änderung der Magnetfeldverteilung sequentiell aus der zeitlichen Änderung der Phase der Bilddaten berechnet wird ("dynamische Referenz").

**8.** Verfahren nach Anspruch 1, **dadurch gekennzeichnet, dass** die Aufnahmeschritte ($S_1 \ldots S_n$) für eine Referenzmessung zur Magnetfeldverteilung zu Beginn der Messung durchgeführt wird und während der Messung jeweils nur noch die Änderung der Magnetfeldverteilung durch weitere Aufnahmeschritte ($S_1 \ldots S_m$) periodisch wiederholend gemessen wird ("statische Referenz").

## Claims

**1.** Magnetic resonance (NMR) method for fast dynamic and spatially resolved measurement of the temporal changes of NMR signals by means of repeated data acquisitions in individual measurements (Acq) with measuring sequences which are sensitive to a parameter to be observed, in an NMR apparatus with shim coils which correct the magnetic field, **characterized in that** the magnetic field distribution in the NMR apparatus is measured completely (S1 ... Sn) or partially (S1 ... Sm) in acquisition steps which are performed with a time lag from the data acquisition of individual measurements (Acq), from which technically or physiologically based changes in the magnetic field distribution and a change of the currents, required for compensation thereof, in the shim coils which correct the magnetic field are determined in a calculation step ($S_{calc}$), and the dynamic changes in the magnetic field distribution are compensated for using the correspondingly changed shim currents.

**2.** Method according to claim 1, **characterized in that** the magnetic field distribution is determined through acquisition steps ($S_1 \ldots S_n$) using so-called "navigators", wherein each navigator is used in the form of an acquisition of a signal which is one-dimensional in k-space, such that at least n=3 navigators are required in the three spatial directions to determine the three-dimensional magnetic field distribution.

**3.** Method according to claim 2, **characterized in that** during each individual measurement (Acq) only m navigators are acquired, wherein 1<m≤ n, such that determination of the spatial magnetic field distribution is completed not until n/m individual measurements (Acq) are finished, wherein, however, after each individual measurement (Acq) a new magnetic field distribution is determined from the respectively preceding n/m individual measurements (Acq).

**4.** Method according to claim 1, **characterized in that** the magnetic field distribution is performed through additionally introduced measurements using two- or three-dimensional sequences (EPI(te1), EPI(te2)) having a low spatial resolution and being sensitive to inhomogeneities, such as e.g. the echo planar imaging method, wherein at least two sequences (EPI(te1), EPI(te2)) are carried out at different echo times to determine the local resonance frequencies caused by the field.

**5.** Method according to claim 4, **characterized in that** during each individual measurement (Acq) only part of the data required for complete measurement of the magnetic field distribution is acquired, such that determination of the spatial magnetic field distribution is completed not until several individual measurements (Acq) are finished wherein, however, after each individual measurement (Acq) a new magnetic field distribution is determined from the respectively preceding individual measurements (Acq).

**6.** Method according to claim 1, **characterized in that** the magnetic field distribution is calculated without additional measuring steps directly from the phase change of the image data caused by periodic change of the echo time.

**7.** Method according to claim 6, **characterized in that** the change in the magnetic field distribution is sequentially calculated from the temporal phase change of the image data ("dynamic reference").

**8.** Method according to claim 1, **characterized in that** the acquisition steps ($S_1 \ldots S_n$) for a reference measurement for magnetic field distribution are performed at the start of the measurement and, during the measurement only the change in the magnetic field distribution is measured in a periodically repetitive manner by means of further acquisition steps ($S_1 \ldots S_m$) ("static reference").

## Revendications

**1.** Procédé de résonance magnétique (RMN) pour une mesure locale dynamique rapide de la correction temporelle de signaux RMN par des enregistrements de données répétées lors de mesures individuelles (Acq) avec des séquences de mesures sensibles par rapport à un paramètre à observer dans un appareil de RMN avec des bobines de shim corrigeant le champ magnétique, **caractérisé en ce que**

une mesure complète (51...Sn) ou partielle (51...Sm) de la de là, lors d'une étape de calcul (Scalc), des modifications techniques ou physiologiques de la répartition de champ magnétique et une modification des courants nécessaire à sa compensation sont déterminées dans les bobines de shim corrigeant le champ magnétique,

et les modifications dynamiques de la répartition de champ magnétique sont compensées grâce aux courants de shim modifiés en conséquence.

2. Procédé selon la revendication 1, **caractérisé en ce que** la répartition de champ magnétique est détectée par des étapes d'enregistrement ($S_1...S_n$) grâce auxdits "navigateurs", dans lequel un navigateur est utilisé respectivement sous la forme d'un enregistrement d'un signal unidimensionnel dans espace k, de sorte qu'au moins n=3 navigateurs sont nécessaires dans les trois directions spatiales pour déterminer la répartition de champ magnétique tridimensionnelle.

3. Procédé selon la revendication 2, **caractérisé en ce que** seulement m navigateurs sont enregistrés lors de chaque mesure individuelle (Acq), dans lequel $1 < m \leq n$, de sorte que la détermination complète de la répartition spatiale de champ magnétique se produit après n/m mesures individuelles (Acq), dans lequel toutefois, après chaque mesure individuelle (Acq), une nouvelle répartition de champ magnétique est déterminée à partir des n/m mesures individuelles (Acq) précédentes respectives.

4. Procédé selon la revendication 1, **caractérisé en ce que** la répartition de champ magnétique est effectuée par des mesures supplémentaires au moyen de séquences (EPI(te1), EPI(te2)) bidimensionnelles ou tridimensionnelles sensibles à l'inhomogénéité à basse résolution spatiale comme par exemple le procédé Echo Planar Imaging (imagerie écho planaire), dans lequel au moins deux séquences (EPI(te1), EPI(te2)) sont effectuées en des temps d'écho différents pour déterminer les fréquences de résonance dépendantes du champ locales.

5. Procédé selon la revendication 4, **caractérisé en ce que**, lors de chaque mesure individuelle (Acq), seule une partie des données nécessaires à la mesure complète de la répartition de champ magnétique est enregistrée, de sorte que la détermination complète de la répartition spatiale de champ magnétique est effectuée après plusieurs mesures individuelles (Acq), dans lequel toutefois, après chaque mesure individuelle (Acq), une nouvelle répartition de champ magnétique est déterminée à partir des mesures individuelles (Acq) précédentes respectives.

6. Procédé selon la revendication 1, **caractérisé en ce que** la répartition de champ magnétique est calculée sans étapes de mesure supplémentaires directement à partir du changement de phase des données d'image, provoqué par la modification périodique du temps d'écho.

7. Procédé selon la revendication 6, **caractérisé en ce que** la modification de la répartition de champ magnétique est calculée séquentiellement à partir de la modification temporelle de la phase des données d'image ("référence dynamique").

8. Procédé selon la revendication 1, **caractérisé en ce que** les étapes d'enregistrement ($S_1...S_n$) sont effectuées pour une mesure de référence en vue de la répartition de champ magnétique au début de la mesure et pendant la mesure, respectivement, la modification de la répartition de champ magnétique est mesurée périodiquement de façon répétée par d'autres étapes d'enregistrement ($S_1...S_m$) ("référence statique").

Fig.1A

Fig.1B

$S_1...S_m$    Acq    $S_{n-m+1}...S_n$    Acq

t

$S_{calc}$    $S_{calc}$

nrep*m/n

**Fig.2**

EPI(te1)    Acq    EPI(te2)    Acq

t

$S_{calc}$    $S_{calc}$

nrep/2

**Fig.3**

$S_1...S_n$        $S_1...S_m$        Acq

$S_{calc}$      $S_{calc}$

nrep

**Fig.4**

Acq

$S_{calc}$

nrep

**Fig.5**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **FRISTON, K.J. ; ASHBURNER, J. et al.** Spatial realignment and normalization of images. *Hum Brain Mapp,* 1995, vol. 2, 165-89
- **GRUETTER, R.** Automatic, localized in vivo adjustment of all first- and second-order shim coils. *Magn Reson Med,* 1993, vol. 29 (6), 804-11
- **JEZZARD, P. ; R. S. BALABAN.** Correction for geometric distortion in echo planar images from B0 field variations. *Magn Reson Med,* 1995, vol. 34 (1), 65-73
- **MANSFIELD, P.** Multi-planar image formation using NMR spinechoes. *J Phys C,* 1977, vol. 10, L5-L58
- **ROBSON, M. D. ; J. C. GORE et al.** Measurement of the point spread function in MRI using constant time imaging. *Magn Reson Med,* 1997, vol. 38 (5), 733-40
- **THESEN, S. ; O. HEID et al.** Prospective acquisition correction for head motion with image-based tracking for real-time fMRI. *Magn Reson Med,* 2000, vol. 44 (3), 457-65
- **ZENG, H. ; R. T. CONSTABLE.** Image distortion correction in EPI: comparison of field mapping with point spread function mapping. *Magn Reson Med,* 2002, vol. 48 (1), 137-46